# EUROPÄISCHE PATENTANMELDUNG

(11) **EP 0 704 990 A1**
(43) Veröffentlichungstag der Anmeldung: **03.04.1996**
(21) Anmeldenummer: 95115147.1
(22) Anmeldetag: 26.09.1995
(51) Int. Cl.: H04B 7/185

(54) **Schaltungsanordnung für Satellitenkommunikation mit Frequenzumsetzer, Verstärker und Leistungsmesser**

(30) Priorität: 29.09.1994 DE 4434903
(71) Anmelder: Richard Hirschmann GmbH & Co., D-72606 Neckartenzlingen (DE)
(72) Erfinder: Lange, Werner, Dr. Ing., D-73732 Esslingen (DE); Nottensteiner, Anton, Dipl.-Ing., D-82297 Steindorf (DE)
(74) Vertreter: Geyer, Ulrich F., Dr. Dipl.-Phys.

(57) **Zusammenfassung**

In Zusammenhang mit einer Sendeanlage für die Satellitenkommunikation, die eine Schaltungsanordnung mit einem Frequenzumsetzer und einem Verstärker aufweist, ergibt sich eine besonders einfach aufgebaute und im Betrieb zuverlässige Schaltungsanordnung dadurch, daß die Schaltungsanordnung einen Leistungsmesser aufweist. Dieser ist dem Verstärker nachgeschaltet und kann zu Regelungszwecken verwendet werden.

## Beschreibung

Die Erfindung betrifft eine Schaltungsanordnung für die Satellitenkommunikation mit einem Frequenzumsetzer und einem Verstärker.

Heutzutage werden für die Kommunikation immer häufiger Satelliten eingesetzt. Als Beispiel sei das VSAT-Satellitenkommunikationssystem genannt. Für das Senden müssen je nach Anwendungsfall verschiedene Sendeleistungen bereitgestellt werden. Die Sendeleistung hängt von den temperatur- und frequenzabhänigigen Schwankungen der gesamten Satellitenkommunikationsanlage ab. Bei den bisher bekannten Anlagen für Satellitenkommunikation werden Leistungsverstärker bzw. -stufen mit höherer Ausgangsleistung in separaten Gehäusen dem Frequenzumsetzer nachgeschaltet, weil eigene Gehäuse die Wärmeableitung verbessern. Dies führt jedoch zu einem höheren Raumbedarf und erhöht den Aufwand für die eigene Stromversorgung. Separate Leistungsstufen machen jedoch einen aufwendigen Wetterschutz erforderlich und verursachen Probleme durch zusätzliche Ein- und Ausgänge, Durchführungen und Kabelverbindungen, die alle Verluste besitzen, Störungen einfangen und wasserdicht bzw. wettergeschützt ausgeführt sein müßten. Darüberhinaus ist an einer Satellitenantenne wenig Platz für eine anzubringende Leistungselektronik vorhanden. Bei den bekannten Anlagen mit Leistungen größer als 2 Watt ist auch keine Messung und/oder Regelung der Sendeleistung vorgesehen.

Der Erfindung liegt daher die Aufgabe zugrunde eine Schaltungsanordnung für die Satellitenkommunikation zu schaffen, die einfach aufgebaut und zuverlässig in Betrieb ist und die gestattet, die Ausgangsleistung zu messen und/oder zu regeln.

Die gestellte Aufgabe wird erfindungsgemäß dadurch gelöst, daß die eingangs genannte Schaltungsanordnung einen Leistungsmesser aufweist.

Durch einen Leistungsmesser kann die Ausgangsleistung (z. B. im Sendefall) gemessen und zu Dokumentationszwecken, aber auch zur Regelung verwendet werden. Die erfaßte Sendeleistung ist an ein Endgerät, z. B. in einem Betriebsgebäude, drahtlos, aber auch mit einem Kabel übertragbar.

In einem bevorzugten Ausführungsbeispiel der Erfindung ist der Leistungsmesser dem Verstärker, der vorzugsweise ein Leistungsverstärker ist, nachgeschaltet. Im Fall, daß ein Ausgangssignal des Leistungsmessers ein Regelsignal für die Leistung ist, d. h. eine geeignete Rückkopplung vorgesehen ist, wird die Ausgangsleistung geregelt.

In einem weiteren bevorzugten Ausführungsbeispiel ist der Leistungsmesser zur Regelung der Ausgangsleistung wenigstens eines Teils der Schaltungsanordnung vorgesehen.

Bevorzugterweise sind der Frequenzumsetzer, der Verstärker und der Leistungsmesser in einem Gehäuse integriert, was hinsichtlich der Abschirmung und des Wetterschutzes aber auch für die Montierbarkeit an die Satellitenantenne vorteilhaft ist. Die Größe des Gehäuses ist vorzugsweise an den einzusetzenden Verstärker angepaßt.

Vorteilhafterweise ist der Leistungsmesser aus dem Gehäuse entfernbar. Dies ermöglicht eine einfache und separat durchführbare Kalibrierung. Die gesamte Anordnung muß nicht einem vorherbestimmten Temperaturzyklus unterworfen werden, sondern nur ein kleiner Teil mit geringer Masse, was den Eichvorgang vereinfacht und insbesondere beschleunigt.

Vorteilhafterweise ist das Gehäuse am Konverter der Satellitenantenne angeordnet. Daher fallen unerwünschte separate Kabelverbindungen zu den einzelnen Gehäusen weg und die Schaltungsanordnung ist kompakt aufgebaut, wobei die Satellitenantenne bzw. der Konverter immer noch beweglich oder drehbar (z. B. zu Ausrichtungszwecken) sind bzw. ist.

Ein weiterer Aspekt der Erfindung besteht darin, daß die Sendeanlage für die Satellitenkommunikation mindestens zwei Schaltungsanordnungen aufweist, die einen Frequenzumsetzer, einen Verstärker und einen Leistungsmesser aufweisen.

Durch diese kompakte Anordnung wird eine, z. B. am Speisesystem befestigbare, Schaltung geschaffen, die nach dem Redundanzprinzip umgeschaltet werden kann.

Die Erfindung sowie weitere besondere Ausgestaltungen und Vorteile derselben wird bzw. werden im folgenden unter Bezugnahme auf die Figuren erläutert. Es zeigen:
- Fig. 1: eine schematische Darstellung des innenmodularen Aufbaus einer erfindungsgemäßen Schaltungsanordnung für einen Verstärker kleiner Leistung;
- Fig. 2: eine schematische Darstellung des innenmodularen Aufbaus einer erfindungsgemäßen Schaltungsanordnung für einen Verstärker mittlerer Leistung;
- Fig. 3: eine schematische Darstellung des innenmodularen Aufbaus einer erfindungsgemäßen Schaltungsanordnung für einen Verstärker hoher Leistung;
- Fig. 4: eine schematische Darstellung des Einsatzes einer Redundanzschaltung in der Empfangs- und Sendeeinrichtung einer erfindungsgemäßen Anlage für die Satellitenkommunikation;
- Fig. 5: eine schematische Darstellung der Montage der erfindungsgemäßen Schaltungsanordnung an den Konverter einer Satellitensende- bzw. -empfangsanlage; und
- Fig. 6: eine schematische Darstellung einer konventionellen Satellitensende- bzw. -empfangsanlage.

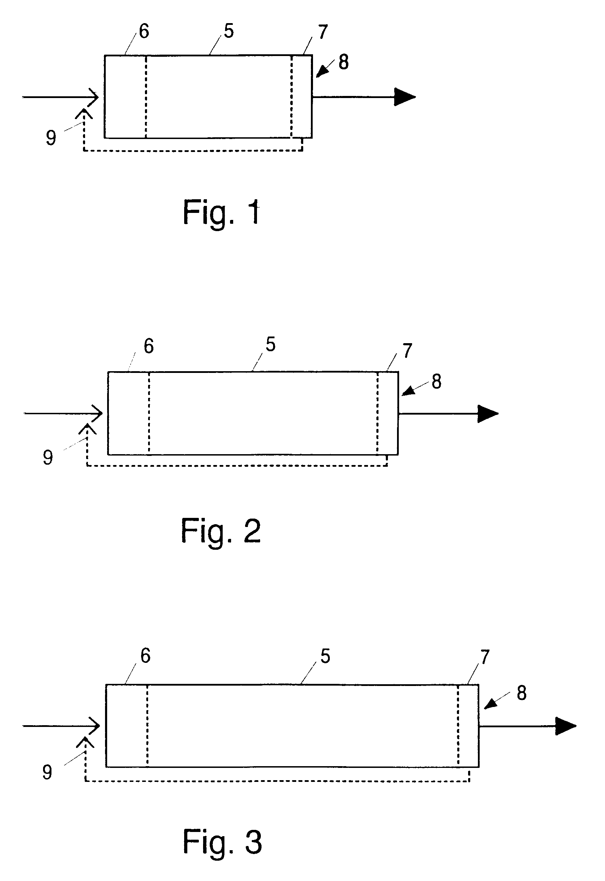

Die Fig. 1 bis 3 zeigen eine schematische Darstellung des innenmodularen Aufbaus einer erfindungsgemäßen Schaltungsanordnung für verschiedene Klassen von Leistungsverstärkern 5. Gemäß diesen Ausführungsformen der Erfindung ist der Frequenzumsetzer 6, der Leistungsverstärker 5 und der Leistungsmesser 7 in einem Gehäuse 8 integriert. Über eine Verbindung 9, die ein Kabel darstellt, aber auch drahtlos sein kann, wird das Ausgangssignal des Leistungsmessers 7 zur Regelung der Ausgangsleistung der Schaltungsanordnung verwendet.Es sind jedoch auch Ausführungsformen möglich, bei denen die Verbindung 9 auch nur im Frequenzumsetzer 6 bzw. im Leistungsverstärker 5 zurückgeführt ist, um nur einzelne oder Teilkomponenten zu regeln. Bei dem in Fig. 1 gezeigten Ausführungsbeispiel weist der Leistungsverstärker 5 etwa 2 Watt Ausgangsleistung auf. Der in Fig. 2 gezeigte Leistungsverstärker 5 ist für 4 Watt ausgelegt und sein Platzbedarf ist z. B. aus Gründen der Wärmeableitung entsprechend größer. In Fig. 3 ist ein auf 8 Watt ausgerichteter Leistungsverstärker 5 gezeigt.

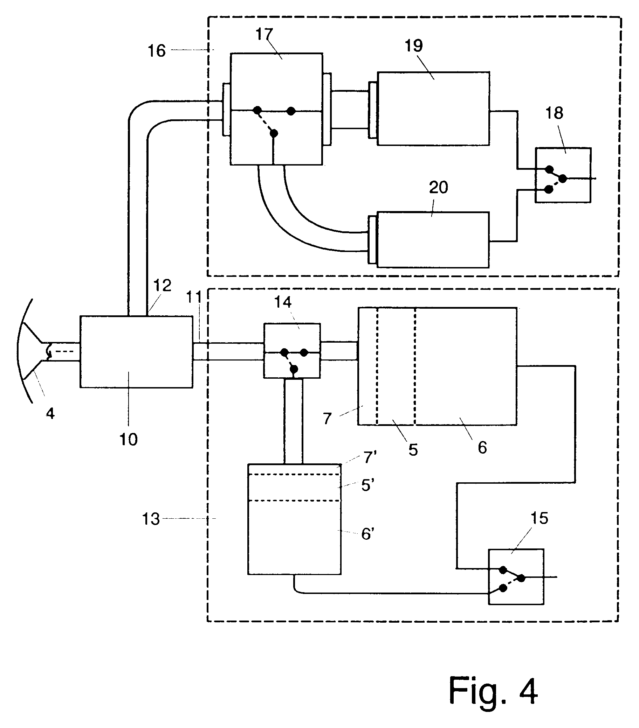

Fig. 4 zeigt die Verwendung von zwei erfindungsgemäßen Schaltungsanordnungen im Zusammenhang mit einer Satellitenanlage. Wie in der Zeichnung durch einen Pfeil angedeutet ist, ist das Speisesystem 4 zusammen mit einer Polarisationsweiche OMT ("orthomode transducer") 10 drehbar verbunden. Der OMT 10 besitzt jeweils einen Ein- bzw. Ausgang 11 und 12. Der Eingang 11 ist mit der Sendeeinrichtung 13 und der Ausgang 12 mit der Empfangseinrichtung 16 verbunden. Sende- bzw. Empfangseinrichtungen 13 bzw. 16 sind durch unterschiedliche Polarisationen von einander entkoppelt. In der Sendeeinrichtung 13 befindet sich direkt anschließend an den Eingang 11 ein Schalter 14, der die Funktion einer Weiche ausübt. In jeder der beiden Schalterstellungen des Schalters 14 ist jeweils ein Ausgang des Schalters 14 mit dem OMT 10 verbunden. Anschließend an die beiden Eingänge des Schalters 14 sind zwei erfindungsgemäße Schaltungsanordnungen mit je einem Frequenzumsetzer 6 bzw. 6', einem Leistungsverstärker 5 bzw. 5' und einem Leistungsmesser 7 bzw. 7' vorgesehen. Die beiden Frequenzumsetzer 6 bzw. 6' sind mit einem dem Schalter 14 entsprechenden Schalter 15 verbunden. Simultanes und koordiniertes Schalten der Schalter 14 und 15 schaltet zwischen den beiden erfindungsgemäßen Schaltungsanordnungen um. Von den vier Schaltzuständen können in geeigneten Schalterstellungen der Schalter 14 und 15 zwei Pfade für die Sendeeinrichtung 13 realisiert werden. Ein Ausweichen auf eine andere Schaltungsanordnung ist dann von Vorteil, wenn z. B. eine Schaltungsanordnung aufgrund eines Defekts ausfällt.

Analog zur Sendeeinrichtung 13 ist die Empfangseinrichtung 16 ausgebildet. Zwei den Schaltern 14 und 15 entsprechende Schalter 17 und 18 bilden die Weichen für zwei in der Empfangseinrichtung vorhandene Pfade, in den sich jeweils ein LNC ("low noice converter") 19 bzw. 20 befindet.

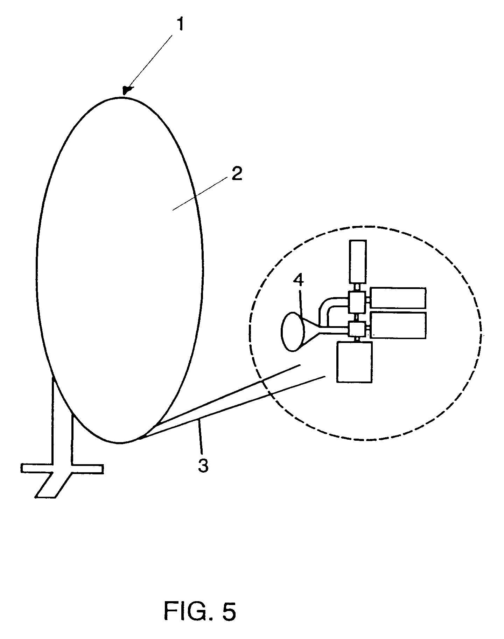

Fig. 5 stellt die Anbringung der in Fig. 4 gezeigten Schaltungsanordnung am Speisesystem 4 einer Satellitensende- bzw. -empfangsanlage 1 dar. Der durch die gestrichelte Linie umrandete Bereich in Fig. 5 entspricht der in Fig. 4 detailliert der dargestellten Schaltungsanordnung

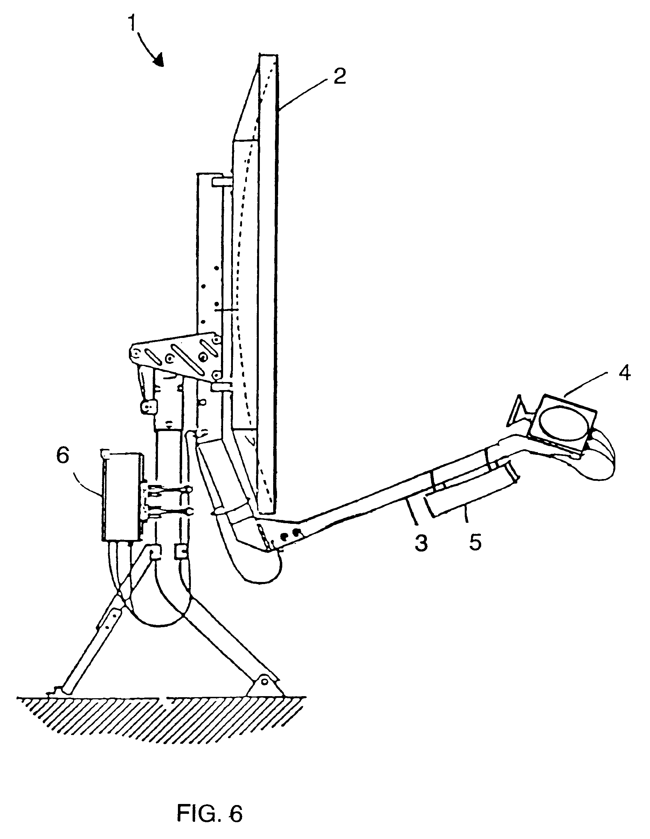

Fig. 6 zeigt eine herkömmliche Satellitensende- bzw. - empfangsanlage 1 mit einer Satellitenschüssel 2 und einem über einem Tragarm 3 befestigten Konverter 4. Der Leistungsverstärker 5 ist, falls erforderlich, ebenfalls am Tragarm 3 befestigt. Ein Frequenzumsetzer UPC 6 ist an einer Befestigungsstrebe der Anlage 1 auf der Rückseite der Satellitenschüssel 2 angebracht.

Die Erfindung wurde zuvor anhand bevorzugter Ausführungsbeispiele erläutert. Dem Fachmann sind jedoch zahlreiche Abwandlungen und Ausgestaltungen möglich, ohne daß dadurch der Erfindungsgedanke verlassen wird. So sei darauf hingewiesen, daß für den Sendefall ausgeführte Merkmal oder Vorteile, der Erfindung ebenfalls sinngemäß für den Empfangsfall gelten und umgekehrt.

## Patentansprüche

1. Schaltungsanordnung für die Satellitenkommunikation, mit einem Frequenzumsetzer (6) und einem Verstärker (5), dadurch gekennzeichnet, daß die Schaltungsanordnung einen Leistungsmesser (7) aufweist.

2. Schaltungsanordnung nach Anspruch 1, dadurch gekennzeichnet, daß der Leistungsmesser (7) dem Verstärker (5) nachgeschaltet ist.

3. Schaltungsanordnung nach Anspruch 1 oder 2, dadurch gekennzeichnet, daß ein Ausgangssignal des Leistungsmessers (7) ein Regelsignal zur Verstärkungsregelung ist.

4. Schaltungsanordnung nach einem der vorhergehenden Ansprüche, dadurch gekennzeichnet, daß das Ausgangssignal des Leistungsmessers (7) zur Regelung der Ausgangsleistung wenigstens eines Teils der Schaltungsanordnung vorgesehen ist.

5. Schaltungsanordnung nach einem der vorhergehenden Ansprüche, dadurch gekennzeichnet, daß der Frequenzumsetzer (6), der Verstärker (5) und der Leistungsmesser (7) in einem Gehäuse (8) integriert sind.

6. Schaltungsanordnung nach einem der vorhergehenden Ansprüche, dadurch gekennzeichnet, daß der Leistungsmesser (7) aus dem Gehäuse (8) entfernbar ist.

7. Schaltungsanordnung nach einem der vorhergehenden Ansprüche, dadurch gekennzeichnet, daß das Gehäuse (8) an einem Speisesystem (4) einer Satellitenantenne (1) angeordnet ist.

8. Schaltungsanordnung nach einem der vorhergehenden Ansprüche, dadurch gekennzeichnet, daß die Satellitenantenne (1) und/oder das Speisesystem (4) drehbar sind/ist.

9. Sendeanlage für die Satellitenkommunikation mit einer Schaltungsanordnung nach einem der vorhergehenden Ansprüche 1 bis 8, dadurch gekennzeichnet, daß eine weitere derartige Schaltungsanordnung aus Redundanzgründen vorgesehen ist.
